# EUROPEAN PATENT APPLICATION

(11) **EP 4 580 027 A1**
(43) Date of publication of application: **02.07.2025**
(21) Application number: 24221632.3
(22) Date of filing: 19.12.2024
(51) Int. Cl.: H02M 3/335, H02M 1/00, G05B 13/04

(54) **METHOD AND SYSTEM FOR CALIBRATING POWER CONVERTERS**

(30) Priority: 29.12.2023 FI 20236449
(71) Applicant: Vensum Power Oy, 02150 Espoo (FI)
(72) Inventor: Baron-Trocellier, Natan, 74350 Cruseilles (FR)
(74) Representative: Moosedog Oy

(57) **Abstract**

Disclosed is method and system for calibrating power converter. Herein, the method comprises initiating one or more characterization tests for power converter, measurements such as voltage, current waveforms, power dissipation, and efficiency of power converter are taken. The method further comprises estimating set of electrical parameters for power converter for each of one or more characterization tests, to provide estimated sets of electrical parameters which include inductance, capacitance, and resistance. The method further comprises combining estimated sets of electrical parameters, to provide consolidated set of electrical parameters. The method further comprises computing control trajectory for power converter based on consolidated set of electrical parameters and in response to change in set of estimated electrical parameters exceeding predetermined threshold in comparison to set of electrical parameters as measured for last operation of power converter. The method further comprises configuring power converter to implement computed control trajectory for operations thereof.

## Description

### TECHNICAL FIELD

The present disclosure relates to methods for calibrating power converters. The present disclosure also relates to systems for calibrating power converters.

### BACKGROUND

With the recent developments in the power electronics, the conversion of electrical energy from one form to the other has become efficient and reliable. The power electronics devices which are capable of converting electrical energy from one form to the other are called the power converters. The conversion process requires some modulation techniques that controls the switching operation of the power converter. The power converters are classified into at least any one of: AC-DC converters, AC-AC converters, DC-DC converters, DC-AC converters. The power converters comprises power electronic control switches such as DIAC, TRIAC, power diode, Power BJT, IGBT, MOSFET, GaN HEMT. Controlling the aforementioned power control switches, the electrical energy can be converted from one the existing form into the desired form. Effective charging along with optimization of efficiency happens when the accurate control of the power converter inside the charger is provided.

A typical power converter has one or two degrees of freedom, which can be controlled using a PID controller. The controller is designed based on a model of the power converter, which often has inaccuracies due to poorly estimated inductance, resistance, and other parameters. However, the controller is designed to be robust, allowing the system to continue operating as specified, even as the system ages. However, there are some cases where a converter has multiple degrees of freedom, making it more challenging to control using a traditional PID controller. In such cases, a control trajectory is used to determine the optimal control parameters for achieving a specific control target. The efficiency of the converter is closely tied to the quality of the control trajectory, which is based on a model of the converter and its estimated electrical parameters.

The control trajectory is based on a model of the power converter and defines a sequence of control parameter values that achieve the desired power transfer characteristics while maximizing the efficiency of the converter. However, the quality of the control trajectory depends on the accuracy of the estimated electrical parameters of the power converter. These parameters may vary due to industrial tolerances or aging, which can result in errors in the control trajectory. Consequently, calibration is required to accurately estimate the electrical parameters of the power converter and ensure that the control trajectory is of high quality.

Therefore, in light of the foregoing discussion, there exists a need to overcome the aforementioned drawbacks associated with existing equipment and techniques for calibrating a power converter.

### SUMMARY

The aim of the present disclosure is to provide a method for calibrating a power converter. The aim of the disclosure is achieved by a method which facilitates in calibrating the power converter for ensuring its optimal performance by computing a control trajectory, and thereby improving the power converter to respond more accurately and quickly to control and system disturbances, leading to improved efficiency and reliability, as defined in the appended independent claims to which reference is made to. Advantageous features are set out in the appended dependent claims.

The aim of the present disclosure is to provide a system for calibrating a power converter. The aim of the disclosure is achieved by a system which facilitates in calibrating the power converter for ensuring its optimal performance by computing a control trajectory, and thereby improving the power converter to respond more accurately and quickly to control and system disturbances, leading to improved efficiency and reliability, as defined in the appended independent claims to which reference is made to. Advantageous features are set out in the appended dependent claims.

Additional aspects, advantages, features, and objects of the present disclosure would be made apparent from the drawings and the detailed description of the illustrative embodiments construed in conjunction with the appended claims that follow.

It will be appreciated that features of the present disclosure are susceptible to being combined in various combinations without departing from the scope of the present disclosure as defined by the appended claims.

### BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Moreover, those skilled in the art will understand that the drawings are not to scale. Wherever possible, like elements have been indicated by identical numbers.

Embodiments of the present disclosure will now be described, by way of example only, with reference to the following diagrams wherein:
FIG. 1 illustrates a block diagram of a system for calibrating a power converter, in accordance with one or more embodiments of the present disclosure;
FIG. 2A illustrates a block diagram of an architecture of a system in which a processing arrangement thereof is implemented in the power converter, in accordance with a first embodiment of the present disclosure;
FIG. 2B illustrates a block diagram of an architecture of a system in which a processing arrangement thereof is implemented in a cloud service, in accordance with a second embodiment of the present disclosure;
FIG. 2C illustrates a block diagram of an architecture of a system in which a processing arrangement thereof is implemented in a master computer of a power station, in accordance with a third embodiment of the present disclosure;
FIG. 3 illustrates a flowchart of a method for calibrating a power converter, in accordance with one or more embodiments of the present disclosure; and
FIG. 4 illustrates an exemplary implementation of a system for calibrating a power converter, in accordance with one or more embodiments of the present disclosure.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practising the present disclosure are also possible.

Throughout the description and claims of this specification, the words *"comprise"* and *"contain"* and variations of the words, for example *"comprising"* and *"comprises",* mean *"including but not limited to",* and do not exclude other components, integers, or steps. Moreover, the singular encompasses the plural unless the context otherwise requires: in particular, where the indefinite article is used, the specification is to be understood as contemplating plurality as well as singularity, unless the context requires otherwise.

In a first aspect, an embodiment of the present disclosure provides a method for calibrating a power converter, the method comprising:
- initiating one or more characterization tests for the power converter, wherein measurements, such as voltage and current waveforms, power dissipation, and efficiency of the power converter are taken;
- estimating a set of electrical parameters for the power converter for each of the one or more characterization tests, to provide estimated sets of electrical parameters, wherein the set of electrical parameters include at least one of inductance, capacitance, and resistance;
- combining the estimated sets of electrical parameters, to provide a consolidated set of electrical parameters;
- computing a control trajectory for the power converter based on the consolidated set of electrical parameters and in response to a change in the set of estimated electrical parameters exceeding a predetermined threshold in comparison to a set of electrical parameters as measured for a last operation of the power converter; and
- configuring the power converter to implement the computed control trajectory for operations thereof.

In a second aspect, an embodiment of the present disclosure provides a system for calibrating a power converter, the system comprising:
- one or more sensors configured to measure a set of electrical parameters for the power converter; and
- a processing arrangement configured to:
- initiate one or more characterization tests for the power converter, wherein measurements, such as voltage and current waveforms, power dissipation, and efficiency of the power converter are taken;
- estimate a set of electrical parameters for the power converter for each of the one or more characterization tests using the one or more sensors, to provide estimated sets of electrical parameters, wherein the electrical parameters include at least one of inductance, capacitance, and resistance;
- combine the estimated sets of electrical parameters, to provide a consolidated set of electrical parameters;
- compute a control trajectory for the power converter based on the consolidated set of electrical parameters and in response to a change in the set of estimated electrical parameters exceeding a predetermined threshold in comparison to a set of electrical parameters as measured for a last operation of the power converter; and
- configure the power converter to implement the computed control trajectory for operations thereof.

The present disclosure provides the aforementioned method and the aforementioned system for calibrating power converters. The method and the system provide procedure for computation of the control trajectory, which provides a robust and accurate control of the power converter. By characterizing the power converter and estimating its electrical parameters, the method provides a consolidated set of parameters that can be used to compute a control trajectory for the power converter. This control trajectory can then be used to configure the power converter to implement the computed trajectory during its operation, thereby ensuring optimal performance. By implementing the computed control trajectory, the present method and the system are able to compensate the structural differences and improves the efficiency of the power converter. Moreover, the present method and the system even compensate the aging effect of the power converter and provides a consistent output irrespective of degradation of the components of the power converter. Optionally, the present method and the system also facilitates the storage of the control trajectories which may have been calculated, for future usage.

Beneficially, the aforesaid approach ensures reliable and an accurate current output in the power converter over time, even in the presence of changing electrical parameters caused by aging, environmental drift, or other factors, thereby maintaining consistent and dependable performance. It will be appreciated that the present method and the system ensures long-term accuracy and efficiency in operation of the power converter by comparing electrical parameters measured during prior operations and applying a threshold to trigger recalibration when deviations exceed acceptable limits. Additionally, it enables the recomputation of the control trajectory using updated parameters and dynamically configures the power converter without disrupting ongoing operations, thereby maintaining consistent performance over time.

The term *"power converter"* refers to an electronic circuit that changes the voltage, current, frequency and phase angle of an AC circuit which comprises AC sources and loads. Herein, AC sources refer to any device or equipment that provides an alternating current (AC) output, which may include generators, transformers, or inverters that produce AC power from DC sources such as batteries or solar panels; whereas AC loads refer to any device or equipment that consumes or utilizes AC power, such as industrial machinery, electric vehicles that operates on AC power. There are various types of power converters, i.e., AC-DC converters, DC-AC inverters, and DC-DC converters. In the present disclosure, primarily, DC-DC converters are used. For purposes of the present disclosure, the power converter comprises any one of: a power diode, a thyristor, a Silicon Controlled Rectifier (SCR), a power MOSFET, a GaN HEMT, a power BJT, a power IGBT, a TRIAC, and a DIAC. Optionally, the power converter works in a purely DC circuit comprising DC loads and DC sources.

The present method relates to calibrating the power converter. The term *"calibrating"* herein refers to the process of adjusting a device to produce a desired output. Herein, the calibration of the power converter refers to the process of determining the electrical parameters that affect its behaviour, such as the inductance, capacitance, resistance, and transfer functions of its components. By characterizing and estimating these parameters, the power converter can be configured to operate more efficiently and accurately, which can result in improved performance, reliability, and lifespan. The calibration process ensures that the power converter behaves in a predictable and controlled manner and allows it to be configured to achieve desired performance characteristics, such as voltage regulation, power efficiency, and stability.

The present disclosure allows for in-field calibration of power converters without the need for extensive lab equipment or human intervention. This means that the calibration can be done remotely, without the need for physical presence at the location of the power converter. Additionally, the calibration process can be done quickly and efficiently, which is particularly useful when producing a large number of power converters.

The present disclosure comprises initiating one or more characterization tests for the power converter. The term *"characterization test"* refers to a process of measuring and evaluating the behaviour and performance of a device under specific operating conditions. The purpose of a characterization test is to determine various characteristics of the device, such as its operating range, response to various inputs, and limitations. In the present context of the power converter, the characterization test is performed to estimate value of electrical parameters of the power converter. These various electrical parameters include at least one of: inductance, capacitance, resistance of the power converter. Such electrical parameters are intrinsic to the power converter's behaviour and stability. Therefore, these electrical parameters are used for long-term calibration of the power converter. The characterization test may be performed under different conditions when parameters vary with these conditions; for instance, FET capacitance changes with voltage. The results of a characterization test may be used for adjusting a model of the power converter, upon which the control of the power converter is based, as described in more detail later in the description.

As per embodiments of the present disclosure, the characterization tests are performed on the power converter without human intervention and without the need for specialized laboratory equipment. Further, these characterization tests can be performed either during the normal operation of the system or while the system is not running. For example, the inductance of an inductor in the power converter may drift over time, affecting its electrical characteristic, which is the link between the current I and the voltage V. To estimate the inductance L, fast sensors for current I and voltage V may be added to the power converter. During the operation of the power converter, when the inductor is expected to receive a constant voltage V for a specified time, the inductance L can be deduced by measuring the constant voltage V and taking two current measurements of I spaced by 1µs. This test can be repeated multiple times to obtain an accurate value of inductance L. However, this situation may not happen as often as desired. Therefore, when the power converter is not charging a device, the power converter can be operated with no load to create a situation where inductor voltage V is constant during some time, and measure inductance L as previously described. These characterization tests are repeated multiple times to obtain a more accurate value of inductance L.

In an embodiment, the method comprises initiating the one or more characterization tests based on a predefined schedule. Initiating one or more characterization tests based on a predefined schedule means that the testing is conducted according to a predetermined plan or timeline. The tests may be scheduled to occur at specific times or intervals during the life of the power converter or during specific operating conditions. The predefined schedule may also include the type and scope of the tests to be conducted. By following a predefined schedule, the tests can be conducted in a systematic and consistent manner, allowing for reliable and accurate estimation of the electrical parameters of the power converter. This can help to ensure that the power converter operates optimally and within desired specifications. It can also help to identify potential issues or problems early on, allowing for timely maintenance or repairs.

In another embodiment, the method comprises initiating the one or more characterization tests in response to receipt of a user request. Initiating the one or more characterization tests in response to receipt of a user request means that the user can specifically request a calibration of the power converter, which may be important in certain situations. For example, if the power converter has been operating for a long period of time or has been subject to some external disturbance, the user may want to ensure that the power converter is still operating within the desired parameters. Additionally, if the user is planning to use the power converter in a new application or with different operating conditions, it may be necessary to recalibrate the power converter to ensure optimal performance. By allowing the user to request a calibration, the method provides flexibility and control to the user, and enables them to ensure that the power converter is operating optimally for their specific needs. It may be understood that the user request can be made through a software interface or a physical button on the power converter itself, or any other suitable techniques without any limitations.

In another embodiment, the method comprises initiating the characterization tests based on change in state of operation of the power converter. Initiating characterization tests based on a change in state of operation of the power converter involves automatically triggering the tests when certain events or conditions occur during the operation of the power converter. For example, the tests may be initiated when the power converter is first installed or commissioned, when there is a change in the load being supplied by the power converter, when there is a change in the environmental conditions affecting the power converter's performance, when there is a change in parameters or data sets of the power converter, and/or when there is a change in the configuration or settings of the power converter. This may be done to detect any issues or malfunctions that may arise due to changes in the operating conditions. For instance, if the load being supplied by the power converter changes, it may affect the power converter's efficiency or stability, and the characterization tests can be initiated to ensure that the power converter is still operating within the desired specifications. As another example, if certain measurement results are observed, during testing, or a certain data set is observed, which may affect the operation of the power converter in an unwanted or unspecified way, characterization tests can be started to ensure that the power converter functions according to the desired specifications.

The method further comprises estimating a set of electrical parameters for the power converter for each of the one or more characterization tests, to provide estimated sets of electrical parameters. As discussed, multiple characterization tests may be performed on the power converter. These characterization tests may provide information about the electrical behaviour of the power converter, such as the resistance and inductance of various components, the capacitance of the input and output filter capacitors, and the parasitic capacitances and inductances of the circuit layout, etc. During each characterization test, various measurements of the power converter may be taken, such as voltage and current waveforms, power dissipation, and efficiency. These measurements may be used to estimate the electrical parameters of the power converter for that particular test run, and such estimates all together for multiple characterization tests are referred to, herein, as the estimated sets of electrical parameters. Such measurements are aimed at determining and updating internal electrical parameters for recalibration purposes. Depending on the specific characterization test being performed, different electrical parameters may be estimated. It may be appreciated that these electrical parameters are estimated, as exact measurements of these parameters may not be possible, due to various factors such as noise, limitations in measuring instruments, and changes in operating conditions. This estimation process may involve mathematical modelling and simulation techniques to determine the values of these parameters based on the measured data.

It may be important to take into account the fact that the electrical characteristics of the converter can vary with temperature, current, and voltage. This means that the estimated sets of electrical parameters obtained from the characterization tests may not be completely accurate, as they do not account for these variations. In order to address this issue, a statistical method known as PLANS OF EXPERIENCE (POE) can be applied. POE involves designing and executing a set of experiments that take into account the expected variations in the electrical characteristics of the power converter. By carefully controlling the experimental conditions, it is possible to isolate the effect of each variable on the electrical parameters and obtain more accurate estimates. For example, if temperature is expected to be a significant factor, the experiments may be designed to vary the temperature over a range of values and measure the corresponding changes in the electrical parameters. The results of these experiments can then be used to develop a model of the electrical characteristics of the power converter that takes into account the said variations. This model can be used to adjust the estimated sets of electrical parameters obtained from the characterization tests, resulting in more accurate and reliable calibration of the power converter.

Alternatively, or additionally, to address above-described issue, the method may incorporate precision timing techniques such as synchronizing the measurement equipment with the power converter to ensure accurate measurement at the same time intervals. This can help to minimize the effect of any propagation delays in the measurement of electrical parameters, especially in cases where the power converter operates at high frequencies. In addition, the method may also involve compensating for propagation delays in the measurement of electrical parameters. This can be done by measuring the propagation delay of the measurement equipment and adjusting the measurement time accordingly to ensure accurate results. The method may also incorporate other compensation techniques such as filtering or signal processing to reduce the effect of noise or other sources of error in the measurement of electrical parameters.

The method further comprises combining the estimated sets of electrical parameters, to provide a consolidated set of electrical parameters. In the context of the present disclosure, consolidating the set of electrical parameters estimates refers to combining the estimated sets of electrical parameters obtained from one or more characterization tests into a single, consolidated set of electrical parameters. After multiple characterization tests have been performed, there will be multiple estimated sets of electrical parameters, each corresponding to a particular test run. These estimated sets of electrical parameters may be consolidated or combined to produce a more accurate representation of the actual electrical parameters of the power converter. That is, after estimating the electrical parameters for the power converter for each characterization test, the estimated sets of parameters are combined to produce the consolidated set of electrical parameters. This approach can help to ensure that the power converter is calibrated properly and performs optimally under various operating conditions, improving its overall reliability and performance.

In an embodiment, the method further comprises combining the estimated sets of electrical parameters using statistical techniques. That is, the said consolidation process involves statistical techniques, where the results from multiple tests are averaged or combined using other mathematical methods to obtain a more accurate and representative estimate of the electrical parameters of the power converter. For example, if each estimated set of electrical parameters has an error rate of 5%, combining 100 of these estimated sets can significantly reduce the overall error rate to 0.5%. This is because statistical methods such as averaging can help to eliminate random errors and produce more precise results.

In an example, regression analysis is a statistical technique which may be used for consolidating the measured sets of electrical parameters. Specifically, linear regression is used to frame the relationship between current and voltage, and to consolidate the coefficients of the linear equation that denotes that relationship. In other examples, the statistical techniques which may be employed for the consolidation of the measured sets of electrical parameters includes, but not limited to, Bayesian estimation, Kalman filtering, and the like. It may be appreciated that these techniques are generally useful while dealing with a non-linear set of equation associated with a non-linear system.

The method further comprises computing a control trajectory for the power converter based on the consolidated set of electrical parameters. In a power converter, the input voltage and current are converted to a regulated output voltage and current through a combination of electronic components, such as switches, inductors, capacitors, and diodes. The control circuit of the power converter generates the appropriate signals to the switches in order to achieve the desired output voltage or current. Generally, the control trajectory refers to the reference signal that the power converter should follow in order to achieve the desired output voltage or current. In a power converter, a control trajectory is a map or function that provides the appropriate control parameters to achieve a specific control target under given external conditions of operation. This map is precomputed based on a model of the power converter and is needed when there are a large number of control parameters and many combinations of these parameters can achieve the same result with varying degrees of efficiency.

To ensure that the control trajectory is accurate, the model used to create it must have accurate parameters, such as inductance, capacitance, and resistance. These parameters may change over time due to industrial tolerances, degradation of components, and other factors. Therefore, the present disclosure includes performing characterization tests on the power converter to estimate the electrical parameters and update the control trajectory. By accurately estimating the electrical parameters through characterization tests, the control trajectory can be updated to ensure optimal efficiency and performance of the power converter. This improves the overall reliability of the converter and ensures that it can operate under various external conditions with different control targets.

Computing the control trajectory for the power converter based on the consolidated set of electrical parameters is a crucial step in the calibration process. The computed control trajectory takes into account the electrical characteristics of the power converter, as determined. Specifically, the obtained consolidated set of electrical parameters provides the necessary information for computing the control trajectory. By using the consolidated set of parameters, the control parameters including, but not limited to, duty cycles, switching frequency, deadtimes, the phase delays between two or more switching legs, different thresholds used for hysteresis control (if used), can be optimized to achieve the best possible performance of the power converter. This can include adjusting duty cycle of the switches, switching frequency, and the like.

In an embodiment, the method further comprises computing the control trajectory for the power converter by interpolation of the consolidated set of electrical parameters using a library of precomputed trajectories. As discussed, the control trajectory is often designed based on the characteristics of the power converter and the load it is driving, as well as the requirements of the application. To compute the control trajectory, the method described involves using a library of precomputed trajectories (as determined). This library can be built by generating and storing a set of control trajectories for various combinations of operating conditions of the power converter and target load current on one side, and control parameters such as duty cycles, switching frequency, and the like on the other side. When a new set of electrical parameters is estimated for the power converter, these parameters are used to interpolate the library of precomputed trajectories to find the trajectory that best fits the current operating conditions. The interpolated trajectory can then be applied to the power converter to achieve the desired output.

In the present disclosure, a library of control trajectories is precomputed based on a model of the power converter, where each control trajectory in the library corresponds to a specific value of a characterized parameter of the power converter, such as inductance L. For example, a converter with a single characterized parameter (inductance L) may have a control trajectory library like this: L=1pH → control trajectory 1, L=2µH → control trajectory 2, L=10µH → control trajectory 10, and so on. When the characterization tests are performed and the value of the characterized parameter is estimated (e.g., L=3.5µH), the appropriate control trajectory is selected from the library by interpolation. The interpolation formula can be based on a linear or non-linear function, depending on the specific implementation. For example, a linear interpolation formula could be: "control trajectory = 0.5 * (control trajectory 3) + 0.5 * (control trajectory 4)" if the estimated value of L is between 3µH and 4µH and the control trajectories 3 and 4 correspond to L=3µH and L=4µH, respectively. This way the appropriate control trajectory can be selected for the specific operating conditions of the power converter, based on the estimated value of the characterized parameter, resulting in improved efficiency and performance thereof.

The use of precomputed trajectories may help reduce the computational complexity for the present method, as it eliminates the need for real-time calculation of trajectories. Herein, the library of precomputed control trajectories can be used in order to reduce computational power and memory requirements instead of computing control trajectories on the fly. This is particularly useful in systems with a large number of possible control parameters, where a vast number of control trajectories would need to be computed regularly. By precomputing the library of control trajectories, the control parameters for a given external condition and control target can be looked up quickly and efficiently. Additionally, precomputed trajectories may help ensure a high degree of accuracy and repeatability for the power converter, as the trajectories have already been optimized and validated for the specific power converter and operating conditions.

In an embodiment, the method further comprises computing the control trajectory for the power converter by adapting the consolidated set of electrical parameters using a set of precomputed gradients. That is, to compute the control trajectory, a set of precomputed gradients are used to adapt the consolidated set of electrical parameters. As used herein, "gradients" generally refers to the rate of change of a quantity with respect to another quantity, and in this context, it refers to the rate of change of the consolidated set of electrical parameters with respect to the control trajectory. The precomputed gradients are calculated in advance and stored in a library for use during the calibration process. These gradients provide a set of predetermined values that are used to adjust the electrical parameters based on the current operating conditions of the power converter. By using precomputed gradients, the process of computing the control trajectory may be made more efficient and accurate, as the gradients provide information on how changes in the control trajectory affect the electrical parameters of the power converter. This allows for faster adaptation of the consolidated set of electrical parameters to achieve the desired control trajectory.

For instance, in a Dual Active Bridge (DAB) power converter, Zero Voltage Switching (ZVS) is a desirable operating condition as it reduces switching losses and improves efficiency. Achieving ZVS requires the control parameters of the power converter to be precisely set to the correct values. However, due to manufacturing variability, environmental factors, degradation over time, and other sources of error, the actual electrical parameters of the power converter may differ from the ideal values. The present method using precomputed gradients involves calculating a set of gradients or changes to the electrical parameters based on a pre-existing set of data or simulation results. These gradients can be used to adjust the estimated electrical parameters of the DAB converter to achieve ZVS more efficiently and accurately.

The method comprises computing the control trajectory for the power converter in response to the change in the set of estimated electrical parameters exceeding the predetermined threshold in comparison to the set of electrical parameters as measured for the last operation of the power converter. That is, the method involves monitoring the estimated electrical parameters of the power converter, and if there is a change in these parameters that exceeds the predetermined threshold compared to the last measured set of electrical parameters for the power converter, then the control trajectory of the power converter is recomputed. This is done to ensure that the control trajectory of the power converter is updated in response to changes in the electrical parameters that may affect its performance. This predetermined threshold applies to deviations in the internal electrical parameters, triggering recalibration to maintain performance of the power converter over time. The recomputation of the control trajectory is based on recalibrated internal electrical parameters when said deviations exceed the predermined threshold. This approach ensures long-term reliability and accuracy despite gradual parameter drift which may be caused by factors like aging or environmental changes or similar.

For instance, over time, some of the electrical components in the power converter may degrade or fail, resulting in a change in the electrical parameters of the converter. If this change exceeds a predetermined threshold, it may affect the performance of the power converter, and thus the control trajectory needs to be recomputed to compensate for this change. By continuously monitoring the estimated electrical parameters and recomputing the control trajectory in response to significant changes, the present method may ensure that the power converter is operating optimally and reliably, even in the face of changes to the electrical parameters over time. For example, if the change of electrical parameters is caused by degradation of the power converter, adapting the control trajectory means adapting the power converter so it can still work in a reduced fashion even when hardware is damaged.

As used herein, the "predetermined threshold" refers to a pre-defined value that is set as a limit for the acceptable deviation in the estimated electrical parameters of the power converter. If the change in the estimated electrical parameters exceeds this threshold, it indicates a significant deviation from the previous measurements, and the control trajectory is computed to adjust for these changes. The predetermined threshold can be set based on various factors such as the desired level of precision, the expected range of variations in the electrical parameters, and the acceptable level of performance for the power converter. In a non-limiting example, the predetermined threshold is an average of the estimated set of electrical parameters that were calculated historically.

The method further comprises configuring the power converter to implement the computed control trajectory for operations thereof. That is, after the control trajectory has been computed based on the consolidated set of electrical parameters, the method involves configuring the power converter to implement this trajectory during its operations. This typically involves adjusting the settings of a controller of the power converter to ensure that it follows the computed control trajectory accurately. Configuring the power converter to implement the computed control trajectory helps in achieving the desired performance and reliability of the power converter. For example, if the control trajectory is designed to achieve the ZVS in the DAB power converter, as described in example above, then configuring the power converter to follow the computed control trajectory may significantly reduce turn-on commutation losses and improve efficiency, resulting in better performance and longer lifespan of the power converter.

In an example, the method comprises stopping operations of the power converter while configuring the power converter to implement the computed control trajectory therefor. When configuring the power converter to implement the computed control trajectory, it may be necessary to stop the operations of the power converter temporarily to ensure a smooth transition from the current control trajectory to the new control trajectory. This is because the new control trajectory may be inconsistent from previously implemented control trajectory, so operating the system while control trajectory is being updated may lead to software bugs, instability, or fatal errors. Stopping the operations of the power converter allows for a controlled and safe reconfiguration process, ensuring that the new control trajectory is implemented correctly and without interruption. During this temporary stoppage, the power converter may enter a standby mode or be disconnected from the load, depending on the specific application and control strategy. Once the power converter has been properly configured to implement the new control trajectory, it can resume normal operations with improved performance and efficiency.

In an alternate example, the power converter is designed with two memory blocks, namely a first memory block and a second memory block. The current control trajectory implemented by the power converter is stored in the first memory block. The method involves writing the newly computed control trajectory to the second memory block while the power converter is still configured to implement the current control trajectory stored in the first memory block for ongoing operations. This ensures that the power converter continues to operate as expected while the new control trajectory is being computed and stored in the second memory block. Once the new control trajectory is successfully computed and stored in the second memory block, the power converter is then configured to start implementing the new control trajectory for future operations. This process allows for a smooth transition from the current control trajectory to the newly computed trajectory without interrupting the ongoing operations of the power converter. This approach also enables easy and safe experimentation with new control trajectories, as it provides a simple way to revert back to the previous control trajectory if implantation of the new computed control trajectory is not successful.

A technical effect of the aforementioned method is that a reliable and an accurate performance of the power converter is ensured over time, despite long-term changes in electrical parameters, and the control trajectory is dynamically adapted to reflect current electrical characteristics, ensuring optimal efficiency and stability, and a systematic and repeatable method for recalibrating the power converter based on real-time internal parameter monitoring is provided.

The present disclosure also relates to the aforementioned system for calibrating the power converter as described above. Various embodiments and variants disclosed above, with respect to the aforementioned first aspect, apply *mutatis mutandis* to the aforementioned system.

Herein, the system comprises one or more sensors configured to measure the set of electrical parameters for the power converter. That is, the sensor(s) are employed to measure the set of electrical parameters at first place, which may then be used for calibrating the power converter. There are various types of sensors that can be used for said purpose. Some examples include, but not limited to, current sensors, voltage sensors, and temperature sensors. For example, current sensors, such as hall-effect sensors, shunt resistors, and current transformers, may be used to measure the electrical current flowing through the power converter. These sensors may be associated with the power converter in various ways depending on the specific application and the type of sensor being used. In some cases, sensors may be integrated directly into the power converter itself, such as by using on-board temperature or current sensors to measure the current of the power converter.

The system further includes a processing arrangement for executing the steps of the method as described in the preceding paragraphs, and not repeated herein for brevity of the present disclosure. The term "processing arrangement" as used herein refers to a structure and/or module that includes programmable and/or non-programmable components configured to perform the said method steps. Optionally, the processing arrangement is supplemented with additional computation systems, such as neural networks, and hierarchical clusters of pseudo-analog variable state machines implementing artificial intelligence algorithms. In the present examples, the processing arrangement may include components such as memory, a controller, a network adapter and the like, to store, process and/or share information with other components, such as a current sensor, a voltage sensor, a remote server unit, a database. Optionally, the processing arrangement includes, but is not limited to, a microcontroller, a micro-controller, a complex instruction set computing (CISC) microcontroller, a reduced instruction set (RISC) microcontroller, a very long instruction word (VLIW) microcontroller, Field Programmable Gate Array (FPGA) or any other type of processing circuit, for example as aforementioned.

Optionally, the system comprises a memory configured to store a predefined schedule for performing the one or more characterization tests, and wherein the processing arrangement is configured to periodically initiate the one or more characterization tests based on the predefined schedule. Herein, the memory may be communicably coupled to the processing arrangement directly or via a controller as known in the art.

Optionally, the system comprises an input module configured to receive a user request for performing the one or more characterization tests, wherein the processing arrangement is configured to initiate the one or more characterization tests in response to receipt of the user request. It may be appreciated that the user request may be generated by using aforementioned steps.

Optionally, the system comprises a controller associated with the power converter, in which the controller is communicably coupled to the processing arrangement via a communication channel, wherein the communication channel is a wired communication channel and/or a wireless communication channel. The wired communication channel comprises at least one of: a Local area network (LAN), an Ethernet, a twisted pair cable, a coaxial cable, a fibre optic cable. Optionally, the wireless communication channel comprises at least one of: a wi-fi, a Bluetooth, an internet connection. The controller is configured to communicate the measured set of electrical parameters for the power converter to the processing arrangement and further receives the computed control trajectory from the processing arrangement.

In an embodiment, the processing arrangement is implemented in the power converter. This provides that the necessary computational hardware and software are integrated into the power converter itself, which allows for more efficient and streamlined operation, as the power converter can perform the necessary calibration and control functions internally without the need for external hardware or software. This can also improve the overall performance and reliability of the power converter, as it reduces the complexity of the system and minimizes the potential for external interference or malfunction.

In an embodiment, the processing arrangement is implemented in a cloud service. This provides that the processing tasks are offloaded to a cloud service, such as a remote server or cluster of servers, which can be accessed by the power converter or other devices via the Internet. In this scenario, the one or more characterization tests can be initiated and performed by the power converter, and the measured data can be transmitted to the cloud service for processing. The cloud service can then use its processing power and resources to estimate the electrical parameters of the power converter, consolidate the estimates, compute the control trajectory, and configure the power converter accordingly. Such configuration allows for centralized and efficient processing of data from multiple power converters, which can be useful for large-scale deployments of power converters, such as in smart grid or renewable energy systems, where there may be hundreds or thousands of power converters that need to be calibrated and optimized for maximum efficiency and performance. This also can reduce the computational burden on the power converter itself, allowing it to operate more efficiently and with lower power consumption.

In an embodiment, the processing arrangement is implemented in a master computer of a power station. This means that the calibration process is centralized and managed by a master computer that oversees the operation of multiple power converters within the power station. In this scenario, the master computer serves as a central hub for the calibration process, allowing for the coordinated calibration of multiple power converters. The use of a master computer for implementing the processing arrangement can provide several benefits, including increased reliability and consistency in the calibration process, improved overall efficiency and performance of the power converters, and easier maintenance.

In an embodiment, the processing arrangement is implemented partially in the power converter and partially in one or more of: a cloud service, a master computer of a power station. That is, the system utilizes a distributed processing arrangement for calibrating the power converter. For example, the power converter may have a local processing unit that initiates and performs the characterization tests and estimates the electrical parameters based on the sensor measurements. The local processing unit may then communicate with the cloud service to exchange the estimated electrical parameters, which may then compute control trajectories using its processing capabilities that may not be available in the local processing unit. Herein, the said master computer can receive data from multiple power converters in the power station and perform analysis to detect trends and anomalies in the data, specify the electrical parameter requirements for the charging process, so that the power converter can adjust its control trajectory to meet those requirements.

Optionally, for purposes of the present disclosure, the power converter is a DC-DC power converter. DC-DC power converters are widely used in various applications, including electric vehicles, renewable energy systems, and telecommunications. DC-DC power converters are used to convert one DC voltage level to another, and they often operate at high efficiency and power levels. Due to their complex behaviour and the variability of the components used, it can be challenging to accurately estimate the electrical parameters that govern their behaviour, such as inductance and capacitance values. By using the proposed techniques to accurately estimate the electrical parameters, the DC-DC power converter may be calibrated and optimized for specific applications, leading to improved performance and reliability.

In an example, the power converter is a Dual-Active-Bridge (DAB) power converter. The proposed techniques of the present disclosure may particularly be implemented in the DAB power converter, which uses control trajectories to adjust the switching signals of the power converter in order to achieve desired performance objectives, such as Zero Voltage Switching (ZVS). By utilizing control trajectories, the DAB converter can achieve soft-switching in more situations, which is a desirable characteristic for power converters because it reduces switching losses and increases efficiency. Additionally, control trajectories allow for precise and predictable operation of the power converter, making it possible to achieve the desired output voltage and current with high accuracy.

The method and the system for calibrating the power converter, as described in the present disclosure, can be useful in various applications, including renewable energy systems, electric vehicle charging stations, and industrial automation systems. For example, in electric vehicle charging stations, power converters are used for DC-DC power conversion to provide the required output voltage and current for the various charging standards supported by the station. Efficient conversion of power is crucial to minimize charging times and reduce energy losses, which can be achieved through accurate calibration of the power converter. Similarly, in renewable energy systems such as solar power plants, power converters are used to convert DC power generated by solar panels into AC power that can be used by the electrical grid. Calibration of the power converter is important for efficient power conversion, ensuring that the maximum amount of energy generated by the solar panels is converted into usable electrical energy without any significant losses.

The method and the system of the present disclosure may further be implemented to monitor the consolidated set of electrical parameters over time and identify any significant changes or trends, and accordingly use the parameter variations for predictive maintenance purposes. For example, if the consolidated set of electrical parameters for a power converter used in an electric vehicle charging station changes significantly over time, it may be an indication of component wear or other issues that may lead to failure in the future. By monitoring these changes, maintenance can be scheduled for the corresponding power converter before a failure occurs, reducing downtime and repair costs, enabling the power converter to be maintained and operated at peak efficiency and reliability.

### DETAILED DESCRIPTION OF THE DRAWINGS

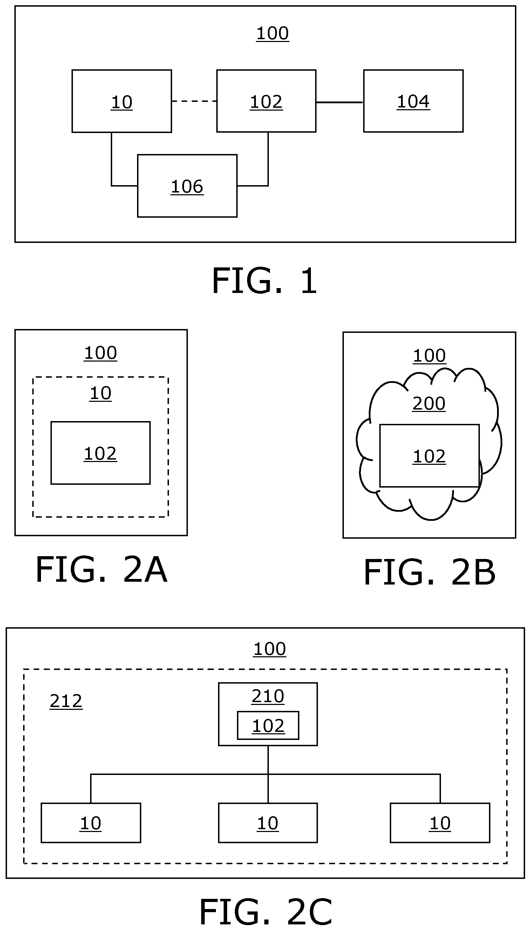

Referring to FIG. 1, illustrated is a block diagram of a system **100** for calibrating a power converter (as represented by reference numeral **10),** in accordance with one or more embodiments of the present disclosure. The system **100** comprises a processing arrangement **102.** The system **100** also comprises a memory **104.** The system **100** also comprises a sensor **106.** The power converter **10** is communicably coupled to the processing arrangement **102.** The sensor **106** is disposed with the power converter **10.** The sensor **106** is also communicably coupled to the processing arrangement **102.**

It may be understood by a person skilled in the art that FIG. 1 includes a simplified architecture of the system **100** for sake of clarity, which should not unduly limit the scope of the claims herein. The person skilled in the art will recognize many variations, alternatives, and modifications of embodiments of the present disclosure.

Referring to FIG. 2A, illustrated is a block diagram of an architecture of the system **100,** in accordance with a first embodiment of the present disclosure. Herein, the processing arrangement **102** of the system **100** is implemented in the power converter **10.** Referring to FIG. 2B, illustrated is a block diagram of an architecture of the system **100,** in accordance with a second embodiment of the present disclosure. Herein, the system **100** comprises a cloud service **200.** The processing arrangement **102** of the system **100** is implemented in the cloud service **200.** Referring to FIG. 2C, illustrated is a block diagram of an architecture of the system **100,** in accordance with a third embodiment of the present disclosure. Herein, the system **100** comprises a master computer **210** of a power station **212.** The master computer **210** is connected to multiple power converters **10** therein. The processing arrangement **102** of the system **100** is implemented in the master computer **210.**

FIGs. 2A-2C are merely examples, which should not unduly limit the scope of the claims herein. A person skilled in the art will recognize many variations, alternatives, and modifications of embodiments of the present disclosure are possible.

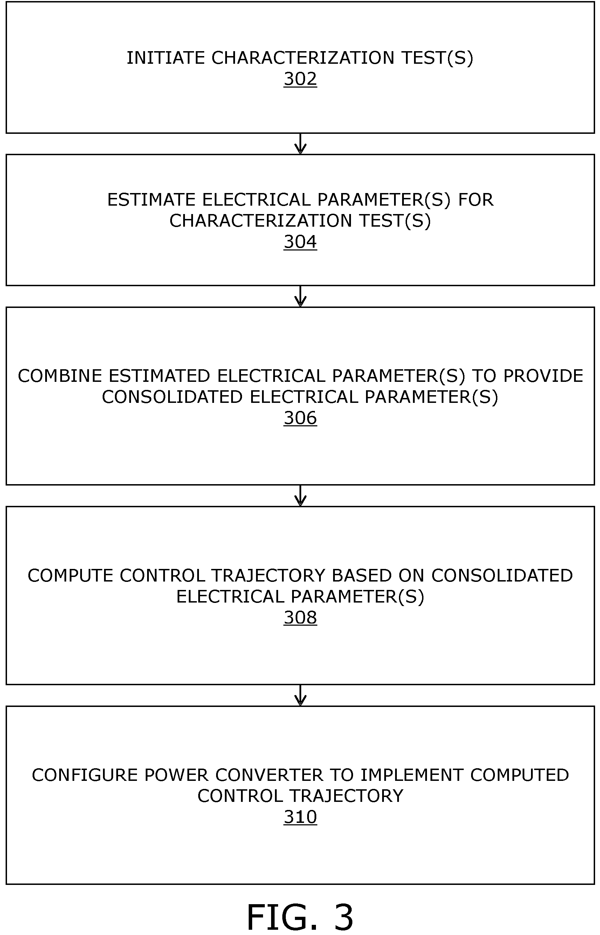

Referring to FIG. 3, illustrated is a flowchart of a method **300** for calibrating a power converter (such as, the power converter **10),** in accordance with one or more embodiments of the present disclosure. At step **302,** one or more characterization tests are initiated for the power converter, wherein measurements, such as voltage and current waveforms, power dissipation, and efficiency of the power converter are taken. At step **304,** a set of electrical parameters for the power converter for each of the one or more characterization tests are estimated, to provide estimated sets of electrical parameters, wherein the set of electrical parameters include at least one of inductance, capacitance, and resistance. At step **306,** the estimated sets of electrical parameters are combined, to provide a consolidated set of electrical parameters. At step **308,** a control trajectory for the power converter based on the consolidated set of electrical parameters is computed and in response to a change in the set of estimated electrical parameters exceeding a predetermined threshold in comparison to a set of electrical parameters as measured for a last operation of the power converter. At step **310,** the power converter is configured to implement the computed control trajectory for operations thereof.

The aforementioned steps are only illustrative and other alternatives can also be provided where one or more steps are added, one or more steps are removed, or one or more steps are provided in a different sequence without departing from the scope of the claims herein.

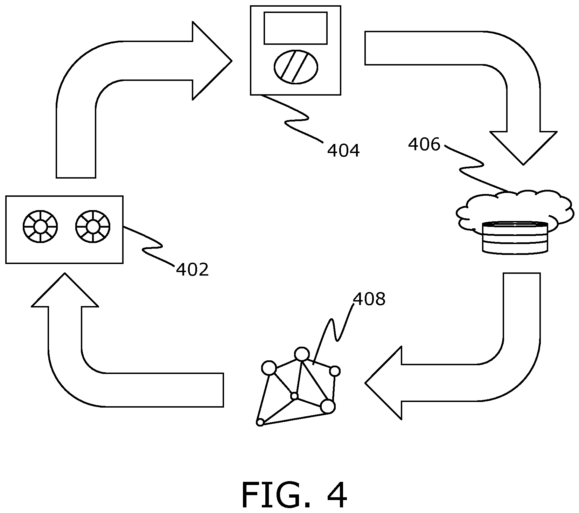

Referring to FIG. 4, illustrated is an exemplary implementation of a system (such as, the system **100)** for calibrating a power converter (such as, the power converter **10),** in accordance with one or more embodiments of the present disclosure. The system comprises at least one power converter (depicted as a power converter **402).** The system comprises at least one measuring instrument (depicted as measuring instrument **404).** The system also comprises simulation and optimization instruments **406.** The system further comprises processing and controlling equipment **408.** Herein, the simulation and optimization instruments **406** and processing and controlling equipment **408** together form backend of the system.

FIG. 4 is merely an example, which should not unduly limit the scope of the claims herein. The person skilled in the art will recognize many variations, alternatives, and modifications of embodiments of the present disclosure.

Modifications to embodiments of the present disclosure described in the foregoing are possible without departing from the scope of the present disclosure as defined by the accompanying claims. Expressions such as "including", "comprising", "incorporating", "have", "is" used to describe and claim the present disclosure are intended to be construed in a non-exclusive manner, namely allowing for items, components or elements not explicitly described also to be present. Reference to the singular is also to be construed to relate to the plural.

## Claims

1. A method for calibrating a power converter, the method comprising:
- initiating one or more characterization tests for the power converter, wherein measurements, such as voltage and current waveforms, power dissipation, and efficiency of the power converter are taken;
- estimating a set of electrical parameters for the power converter for each of the one or more characterization tests, to provide estimated sets of electrical parameters, wherein the set of electrical parameters include at least one of inductance, capacitance, and resistance;
- combining the estimated sets of electrical parameters, to provide a consolidated set of electrical parameters;
- computing a control trajectory for the power converter based on the consolidated set of electrical parameters and in response to a change in the set of estimated electrical parameters exceeding a predetermined threshold in comparison to a set of electrical parameters as measured for a last operation of the power converter; and
- configuring the power converter to implement the computed control trajectory for operations thereof.

2. A method according to claim 1 further comprising initiating the one or more characterization tests based on a predefined schedule.

3. A method according to claim 1 further comprising initiating the one or more characterization tests in response to receipt of a user request.

4. A method according to any one of claims 1 to 3 further comprising computing the control trajectory for the power converter by interpolation of the consolidated set of electrical parameters using a library of precomputed trajectories.

5. A method according to any one of claims 1 to 3 further comprising computing the control trajectory for the power converter by adapting the consolidated set of electrical parameters using a set of precomputed gradients.

6. A method according to any one of preceding claims further comprising combining the estimated sets of electrical parameters using statistical techniques.

7. A system for calibrating a power converter, the system comprising:
- one or more sensors configured to measure a set of electrical parameters for the power converter; and
- a processing arrangement configured to:
- initiate one or more characterization tests for the power converter, wherein measurements, such as voltage and current waveforms, power dissipation, and efficiency of the power converter are taken;
- estimate a set of electrical parameters for the power converter for each of the one or more characterization tests using the one or more sensors, to provide estimated sets of electrical parameters, wherein the electrical parameters include at least one of inductance, capacitance, and resistance;
- combine the estimated sets of electrical parameters, to provide a consolidated set of electrical parameters;
- compute a control trajectory for the power converter based on the consolidated set of electrical parameters and in response to a change in the set of estimated electrical parameters exceeding a predetermined threshold in comparison to a set of electrical parameters as measured for a last operation of the power converter; and
- configure the power converter to implement the computed control trajectory for operations thereof.

8. A system according to claim 7, wherein the processing arrangement is implemented in the power converter.

9. A system according to claim 7, wherein the processing arrangement is implemented in a cloud service.

10. A system according to claim 7, wherein the processing arrangement is implemented in a master computer of a power station.

11. A system according to claim 7, wherein the processing arrangement is implemented partially in the power converter and partially in one or more of: a cloud service, a master computer of a power station.

12. A system according to any one of claims 7 to 11, wherein the power converter is a DC-DC power converter.

13. A system according to any one of claims 7 to 11, wherein the power converter is a Dual-Active-Bridge (DAB) power converter.
